# EUROPEAN PATENT SPECIFICATION

(11) **EP 3 062 380 B1**
(45) Date of publication and mention of the grant of the patent: **26.12.2018**
(21) Application number: 13895949.9
(22) Date of filing: 24.10.2013
(51) Int. Cl.: H01M 10/0562, H01B 1/06, H01B 13/00, H01M 10/0585, C23C 14/34, H01M 10/05, H01B 1/08, H01M 4/38, H01M 4/525

(54) **METHOD OF MANUFACTURING A SOLID ELECTROLYTE**
HERSTELLUNGSVERFAHREN EINES FESTKÖRPERELEKTROLYTES
PROCÉDÉ DE FABRICATION D'UN ELECTROLYTE SOLIDE

(43) Date of publication of application: 31.08.2016
(73) Proprietor: Fujitsu Limited, Kawasaki-shi, Kanagawa 211-8588 (JP)
(72) Inventor: HOMMA, Kenji, Kawasaki-shi Kanagawa 211-8588 (JP); WATANABE, Satoru, Kawasaki-shi Kanagawa 211-8588 (JP); ITOU, Ryouji, Yokohama-shi Kanagawa 222-0033 (JP)
(74) Representative: Haseltine Lake LLP
(86) International application number: PCT/JP2013/078809
(87) International publication number: WO 2015/059794

(56) References cited:
- EP-A1- 3 041 079
- JP-A- 2000 294 291
- JP-A- 2012 009 201
- JP-A- 2013 109 840
- US-A1- 2008 032 200
- US-A1- 2013 183 589
- XU ET AL: "Preparation and electrical properties of NASICON-type structured Li1.4Al0.4Ti1.6(PO4)3 glass-ceramics by the citric acid-assisted sol-gel method", SOLID STATE IONICS, NORTH HOLLAND PUB. COMPANY. AMSTERDAM; NL, NL, vol. 178, no. 1-2, 23 January 2007 (2007-01-23), pages 29-34, XP005929487, ISSN: 0167-2738, DOI: 10.1016/J.SSI.2006.11.009
- S. POISSON ET AL.: 'Crystal Structure and Cation Transport Properties of the Layered Monodiphosphates: Li9M3(P2O7)3(PO4)2 (M=Al, Ga, Cr, Fe' JOURNAL OF SOLID STATE CHEMISTRY vol. 138, no. ISSUE1, June 1998, pages 32 - 40, XP002290225
- Yasser B. Saddeek ET AL: "Influence of MoO3 on the Structure of Lithium Aluminum Phosphate Glasses", ARCHIVES OF ACOUSTICS., vol. 37, no. 3, 1 January 2012 (2012-01-01), XP055421857, PL ISSN: 0137-5075, DOI: 10.2478/v10168-012-0043-2

## Description

### TECHNICAL FIELD

The present invention a method of manufacturing a solid electrolyte, as well as an all-solid-state secondary battery using the solid electrolyte.

### BACKGROUND ART

Energy harvesting to convert micro-energy captured from sunlight, vibrations, body temperatures of humans and animals, etc. into electric energy is being researched and developed. The accumulated electric energy is used for sensor systems, radio transmission power, and other systems using electricity. In energy harvesting, safe and reliable secondary batteries that are operable in any environment on the earth are desired. Liquid batteries which are typically used today have some drawbacks. The cathode active material is degraded upon repetition of battery cycles and the battery capacity decreases. Dendrite-based short-circuiting of a battery is also a concern because the electrolyte organic solvent possibly catches fire. Liquid electrolyte secondary batteries are unsatisfactory in reliability and safety when used in energy harvesting devices intended to operate over a time span of a decade or more. In view of these circumstances, an all-solid-state secondary battery using a solid material for its electrolyte is attracting attention. All-solid-state secondary batteries are unlikely to cause liquid leakage or catch fire, while being superior in cycle characteristics.

As a material of a solid electrolyte of an all-solid-state secondary battery, lithium phosphorous oxynitride (LiPON) is generally used because of its high ionic conductivity. However, pinholes and cracks are easily produced in LiPON based amorphous solid electrolytes, and it is difficult to form a uniform and defectless film. With defects existing in a solid electrolyte, the anode material may reach the cathode (i.e., the positive electrode) through the defects and short-circuit the battery. In this case, the operations of the battery become instable and the production yield decreases.

To solve this problem, a technique for blocking the pinholes and cracks inherently existing in the LiPON based amorphous solid electrolyte by placing lithium carbonate (Li₂CO₃) on the cathode surface is proposed. See, for example, Japanese Patent Application Laid-open Publication No. 2009-272050.

Meanwhile, a single crystal ionic conductor acquired by crystalizing alumina (Al₂O₃) in lithium phosphate flux is known. Seem for example, S. Poisson, et al. "Crystal Structure and Cation Transport Properties of the layered Monodiphosphates: Li9M3(P2O7)3(PO4)2 (M=Al, Ga, Cr, Fe)", Journal of Solid State Chemistry 138, 32-40 (1998).

### SUMMARY OF THE INVENTION

### PROBLEM TO BE SOLVED

In order to use the ionic conductive crystal acquired by this technique in a thin-film all-solid-state secondary battery, additional processes including powdering the crystal, disposing the powder on the cathode, and sintering are necessary. During these processes, ionic conductive film is polycrystallized and cations leak out from the crystal grain boundary. It is difficult to expect appropriate charge and discharge cycles.

It is an objective of the invention to provide a method of manufacturing a solid electrolyte and an all-solid-state secondary battery using the solid electrolyte that achieve stable battery operations.

### MEANS FOR SOLVING THE PROBLEM

According to an aspect described in the disclosure, a method of manufacturing a solid electrolyte, comprising: using a target with a composition of Li₉Al₃(P₂O₇)₃(PO₄)₂; creating plasma; and forming an amorphous solid electrolyte film containing lithium, aluminum, phosphorus, and oxygen over a substrate in an argon atmosphere, a temperature of the substrate being a room temperature during film deposition.

### ADVANTAGEOUS EFFECT OF THE INVENTION

With the above-described method of manufacturing a solid electrolyte, stable battery operation of an all-solid-sate secondary battery is realized.

### BRIEF DESCRIPTION OF DRAWINGS

FIG. 1 illustrates an all-solid-state secondary battery using an amorphous solid electrolyte and a cross-sectional transmission electron microscopy (TEM) image of the all-solid-state secondary battery;
FIG. 2 is an X-ray diffraction diagram representing crystallization of the solid electrolyte at different temperatures of heat treatment;
FIG. 3 is a diagram of infrared absorption spectra of the solid electrolyte at different temperatures of heat treatment;
FIG. 4 is a diagram illustrating the crystalline state of the solid electrolyte along with heat treating temperature;
FIG. 5 illustrates the infrared absorption spectrum of the amorphous solid electrolyte compared with that of a crystalline solid electrolyte;
FIG. 6 is a chart illustrating a discharge curve and a charging curve;
FIG. 7 is a schematic diagram illustrating the structure of a sample fabricated for measurement of battery characteristics;
FIG. 8 is a chart illustrating repetition characteristics of the all-solid-state secondary battery using the solid electrolyte of the embodiment, compared with that of an all-solid state secondary battery using conventional lithium phosphorous oxynitride (LiPON); and
FIG. 9 is a chart illustrating manufacturing yield of the all-solid-state secondary battery using the solid electrolyte of the embodiment, compared with that of the all-solid state secondary battery using conventional lithium phosphorous oxynitride (LiPON).

### DESCRIPTION OF EMBODIMENTS

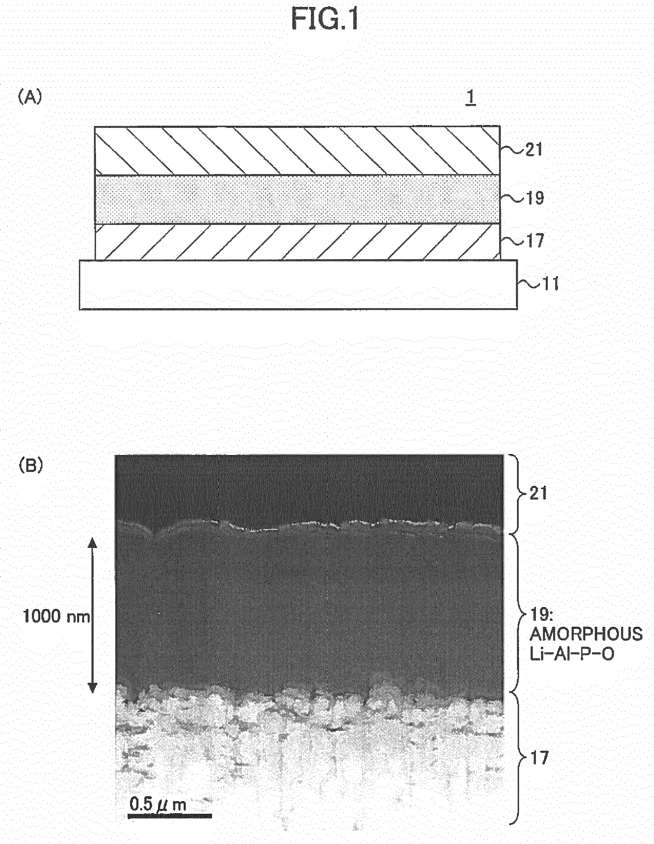

FIG. 1(a) is a schematic diagram of a sample 1 with a solid electrolyte film 19 according to an example, and FIG. 1(b) is a cross-sectional transmission electron microscopy (TEM) image of the sample. In the embodiment, lithium aluminum phosphate (LiAlPO) based amorphous solid electrolyte is provided.

The inventors found that a uniform solid electrolyte film 19 with fewer defects can be obtained by forming a LiAlPO based amorphous film, in place of a LiPON based solid electrolyte material. It is also found that an all-solid-state secondary battery using the solid electrolyte film 19 of the LiAlPO based amorphous film is superior in repetition characteristics and capable of stable battery operations.

In FIG. 1(a), the sample 1 has a LiAlPO based amorphous solid electrolyte film 19 between LiCoO₂ film 17 and lithium metal film 21. FIG. 1(b) is a TEM image of the as-deposited films of the sample 1 in which the solid electrolyte film 19 with a thickness of 1000 nm is deposited over the LiCoO₂ film 17.

The LiAlPO based amorphous solid state electrolyte film 19 is formed by applying alternating current power of 140 W to a target with composition of Li₉Al₃(P₂O₇)₃(PO₄)₂ and generating plasma in an argon atmosphere at a pressure of 0.5 Pa. The substrate temperature during the film deposition is 27 °C.

As understood from FIG. 1(b), cracks are produced in the LiCoO₂ film 17, which film is a thin crystalline layer, in a direction perpendicular to the substrate 11. In contrast, a uniform solid electrolyte film 19 is formed without pinholes or cracks observed according to the embodiment. It is evaluated that the void fraction of the solid electrolyte film 19 of the sample 1 is 0%.

When performing heat treatment on the sample 1 at different temperatures, the amorphous solid electrolyte film 19 is crystalized. Along with the crystallization, pinholes or cracks are generated in the solid electrolyte film 19. To confirm this, an experiment was conducted to determine the crystallization temperature by applying heat treatment to the LiAlPO based solid electrolyte film 19 at various temperatures.

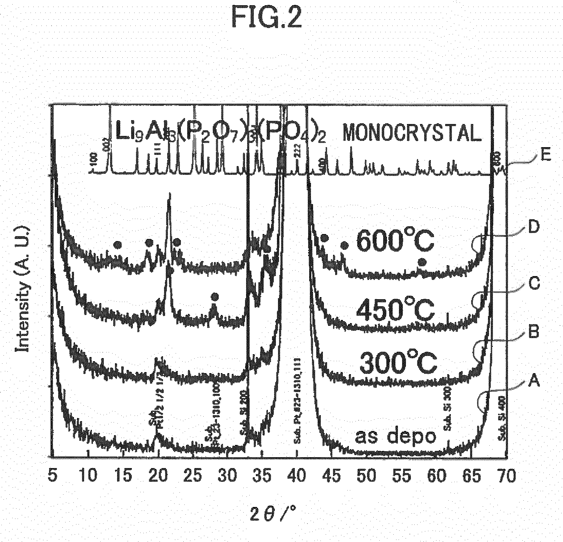

FIG. 2 illustrates measurement results of X-ray powder diffraction when applying heat treatment to the solid electrolyte film 19 in argon atmosphere at 300 °C, 450 °C, and 600 °C. The measurement conditions are tube voltage of 40 kV and tube current of 30 mA. The 2θ range of measurement is from 5° to 70° ( 5° 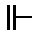 2θ 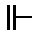 70°) and continuous scan is carried out at a scan rate of 1.2 degrees per minute (1.2°/min) to acquire the diffraction patterns.

In the figure, spectrum A represents an X-ray diffraction pattern of the as-deposited solid electrolyte film 19, spectrum B represents an X-ray diffraction pattern of the heat-treated solid electrolyte film 19 at 300 °C, spectrum C represents an X-ray diffraction pattern of the heat-treated solid electrolyte film 19 at 450 °C, and spectrum D represents an X-ray diffraction pattern of the heat-treated solid electrolyte film 19 at 600 °C. Spectrum E represents the X-ray diffraction pattern of single crystal Li₉Al₃(P₂O₇)₃(PO₄)₂ disclosed in S. Poisson, et al., noted above, which spectrum is presented for reference.

In the diffraction pattern A of the as-deposited film and the diffraction pattern B of the 300-degrees heat-treated film, only diffraction peaks associated with the crystal planes of the substrate 11 are observed. This indicates that the solid electrolyte film 19 is amorphous (uncrystallized). In the diffraction pattern C of the 450 °C heat-treated film, peaks associated with polycrystals produced during crystallization of the LiAlPO based solid electrolyte film 19 are observed as indicated by the dark circles. In the diffraction pattern D of the 600 °C heat-treated film, peaks associated with the crystallization increase.

From FIG. 2, it is understood that the solid electrolyte film 19 is crystallized when heat treatment is performed at a temperature 450 °C or higher.

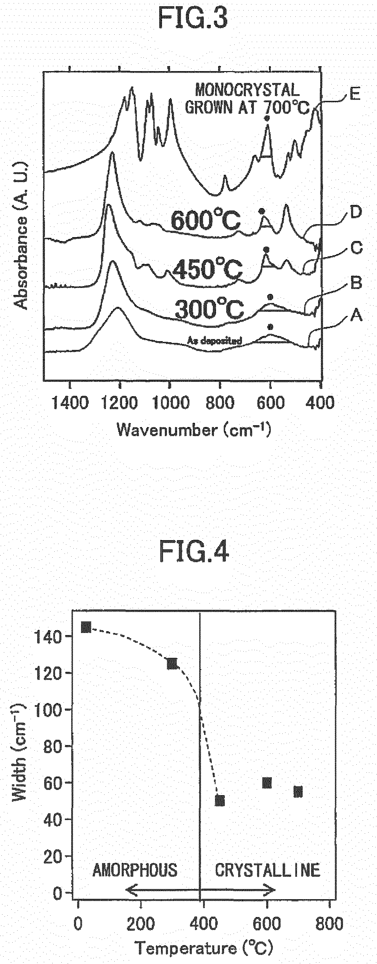

FIG. 3 illustrates infrared absorption spectra acquired by Fourier transform infrared (FT-IR) spectroscopy, which technique is another method for confirming crystallization associated with heat treatment. As equipment for measurement, Nicolet™ 8700 manufactured by Thermo Fisher Scientific Inc., is used and unpolarized IR light is irradiated at an incident angle of 80 degrees to the reflective optics. Interference patterns measured using a glow lamp as a light source, a Michelson interferometer, and a triglycine sulfate (TGS) detector are Fourier transformed. The wavenumber resolution of the equipment is 4 cm⁻¹ and the cumulative number of scans is 64.

In the figure, pattern A represents the spectrum of the as-deposited film, pattern B represents the spectrum of the 300 °C heat treated film, pattern C represents the 450 °C heat treated film, and pattern D represents the 600 °C heat treated film. As a reference, spectrum E of the solid electrolyte of LiAlPO-based single crystal grown at a substrate temperature of 700 °C is presented.

Main peaks indicate vibration of P-O bonds are observed at or near 600 cm⁻¹ of wavenumber (on the horizontal axis). Comparing the observations of the full width at half maximum (FWHM) of the peak of each spectrum, the as-deposited film (Spectrum A) and the 300 °C heat treated film (Spectrum B) exhibit relatively wide FWHM. In contrast, the spectrum C of the 450 °C heat treated film exhibits a narrow FWHM with an abrupt change. This observation result indicates that the LiAlPO-based solid electrolyte film is in the crystalline state at 450 °C.

FIG. 4 is a chart to estimate the temperature at which the LiAlPO-based solid electrolyte changes from the amorphous state to the crystalline state. Based upon the measurement result of FIG. 3, the FWHM [cm⁻¹] of the main peak is plotted as a function of temperature, and interpolation is made between measured points. The FWHM value abruptly decreases beyond 400 °C, falling to 80 cm⁻¹ or below. At heat treatment temperature of 450 °C or higher, the FWHM becomes equal to or less than 60 cm⁻¹. From the estimation, it is assumed that the LiAlPO based solid electrolyte stays in the amorphous state at heat treatment temperature of 400 °C or below.

Based upon FIG. 3 and FIG. 4, it may be defined for the LiAlPO based solid electrolyte that the state with the FWHM value of the main peak indicating the vibration of the P-O bonds at or near 600 cm⁻¹ of FT-IR spectrum equal to or greater than 100 cm⁻¹ is amorphous. Besides, according to FIG. 2, the state in which no diffraction peak except for that from the substrate is observed in the XRD pattern may be defined as "amorphous".

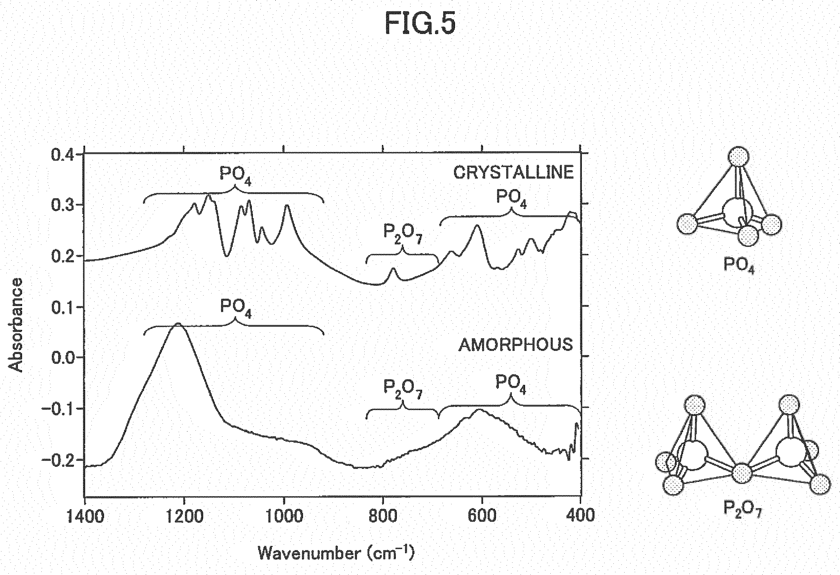

FIG. 5 is a chart illustrating the infrared absorption spectrum of the LiAlPO based amorphous solid electrolyte, compared with the IR absorption spectrum of the LiAlPO based crystalline solid electrolyte of the same composition. The upper spectrum is one from the crystalline solid electrolyte and the lower spectrum is one from the amorphous solid electrolyte in the chart.

The LiAlPO based amorphous solid electrolyte contains phosphorus oxoacids PO₄ and P₂O₇, similarly to the LiAlPO based crystalline solid electrolyte. The PO₄ peak appearing near (on the left side of) 1200 cm⁻¹ in the crystalline solid electrolyte spectrum is due to P-O bond stretching vibration in PO₄ molecules. The other PO₄ peak appearing near (on the right side of) 600 cm-1 in this spectrum is due to P-O-P bond angle bending vibration in PO₄ molecules. The same things apply to the spectra of FIG. 3. When observing and comparing the change in FWHM, either peak may be employed. For example, focusing on the peaks near 600 cm⁻¹, the crystalline solid electrolyte exhibits a sharp peak with narrow FWHM, while the spectrum of the amorphous solid electrolyte changes gently with very wide FWHM.

The crystalline solid electrolyte also exhibits a P₂O₇ peak near 800 cm⁻¹ with narrow FWHM, while no peak is observed in the amorphous solid electrolyte spectrum near this wavenumber.

From FIG. 3 through FIG. 5, the LiAlPO based amorphous solid electrolyte film 19 of the example contains uncrystallized phosphorus oxoacids PO₄ and P₂O₇ and has a uniform film structure with fewer pinholes or cracks. When applying the amorphous solid electrolyte film 19 to an all-solid-state secondary battery, the battery operations become stable.

Because the solid electrolyte film 19 of the example is an oxide, it is not immediately hydrolyzed in the air unlike the conventional nitride based LiPON solid electrolyte film. The solid electrolyte film 19 of the example also has an advantageous effect of ease in handling during the fabrication process of batteries.

By applying heat treatment at or below 400 °C, more preferably at or below 300 °C, to the solid electrolyte of the example, film defects such as voids can be reduced while maintaining the amorphous state.

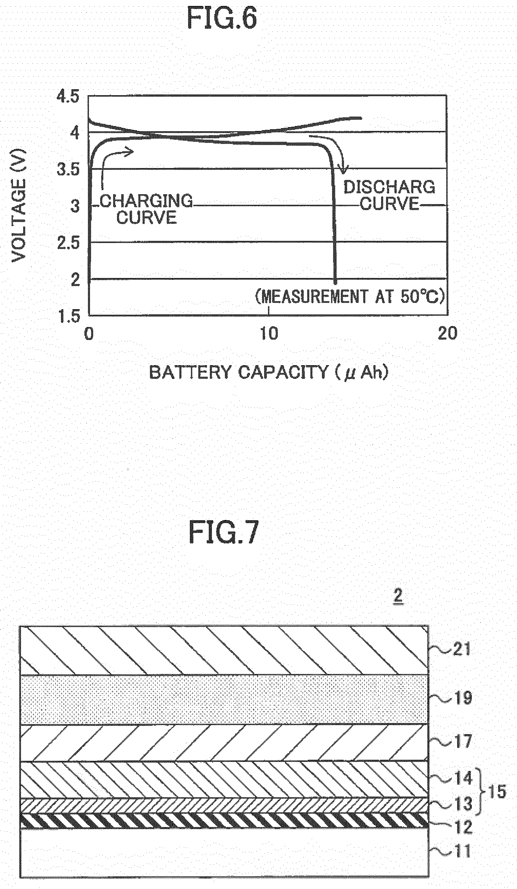

FIG. 6 illustrates a charging curve and a discharge curve of an all-solid-state secondary battery using the solid electrolyte film 19 of the example. To measure the charge and discharge characteristics, a sample of the all-solid-state secondary battery 2 illustrated in FIG. 7 is fabricated. The all-solid-state secondary battery 2 has a layered structure over a substrate 11 on which silicon oxide film 12 is formed, the layered structure including a current collector 15, a positive electrode 17, a solid electrolyte film 19, and a metal film 21 deposited in this order. The metal film 21 serves as a negative electrode and a current collector.

To fabricate the sample, the current collector 15 is formed over the substrate 11 covered with the silicon oxide film 12 with a thickness of 100 nm, by depositing a titanium (Ti) film 13 with a thickness of 30 nm and a platinum (Pt) film 14 with a thickness of 170 nm in this order.

Then, LiCoO₂ film 17, which is a cathode active material, is formed over the current collector 15. The film deposition is performed using a LiCoO₂ alloy target, supplying argon (Ar) gas and oxygen (O₂) gas at volume ratio 3:1, under the conditions of power 600 W, gas pressure 0.5 Pa, and substrate temperature 250 °C. The deposition time is determined depending on the thickness of the positive electrode (liCoO₂ film) 17, which thickness is, for example, 100 nm to 1000 nm. After the film deposition, annealing for crystallization is performed in an oxygen atmosphere at 600 °C for 5 to 10 minutes to produce the positive electrode 17.

Then, the LiAlPO based amorphous solid electrolyte film 19 is formed over the positive electrode 17. The solid electrolyte film 19 with a thickness of 150 nm to 1000 nm is formed using Li₉Al₃(P₂O₇)₃(PO₄)₂ sintered body as a target under the conditions of alternating current power of 70 W to 140 W, in an argon (Ar) atmosphere at a gas pressure of 0.2 to 0.5 Pa, a substrate temperature of room temperature (ambient temperature without applying heat or cooling) and deposition time of 3 to 55 hours. The thinner the solid electrolyte film 19 is, the lower the electric resistance is. However, if the solid electrolyte film 19 is too thin, a short circuit is likely to occur. The thickness of the solid electrolyte film 19 is selected appropriately in the above-stated range. Annealing may be applied to the solid electrolyte film 19 at or below 400 °C, more preferably, at or below 300 °C, as necessary.

Then, a lithium metal film with a thickness of 2 µm is formed as the metal film 21 by vacuum deposition, and the all-solid-state secondary battery 2 is obtained.

Using the fabricated all-solid-state secondary battery 2, a charge and discharge evaluation test is performed. The all-solid-state secondary battery 2 is placed under the environment of temperature 50 °C and dew point temperature -46 °C, and charge and discharge test is carried out at a current density of 48 µA/cm² with electric voltage of 4.2 V and 2.0 V. As the test result, the charge/discharge curve of FIG. 6 is acquired. Because the solid electrolyte film 19 of the all-solid-state secondary battery 2 is a uniform amorphous film with fewer pinholes or cracks as illustrated in FIG. 1(b), satisfactory characteristics can be obtained.

For comparison, an all-solid-state secondary battery with a solid electrolyte having been heat-treated at 450 °C after the film deposition is fabricated and charge and discharge test is performed under the same conditions. In this comparison test, the battery does not work and a charge/discharge curve cannot be acquired. This may be explained by an over discharge having occurred due to cracks generated from the crystal grain boundaries along with the crystallization.

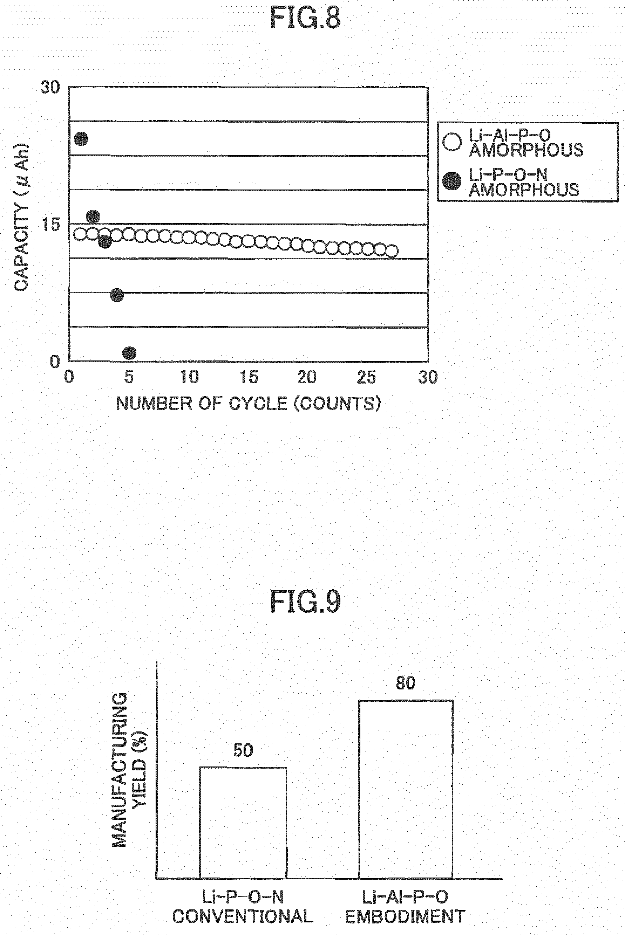

FIG. 8 illustrates charge and discharge repetition (cycle) characteristics of the all-solid-state secondary battery 2 of FIG. 7. The repetition characteristics of the secondary battery using the LiAlPO based amorphous solid electrolyte film 19 are represented by white circles. As a comparison, the repetition characteristics of an all-solid-state secondary battery using the conventional LiPON based amorphous solid electrolyte are represented by dark circles.

The all-solid-state secondary battery 2 using the LiAlPO based amorphous solid electrolyte film 19 exhibits satisfactory capacity retention rate up to 27 cycles. It is understood that this battery operates in a stable manner. In contrast, in the all-solid-state secondary battery using the conventional LiPON based amorphous solid electrolyte, an internal short circuit has occurred due to growth of pinholes and the discharge capacity abruptly decreases. After the 5th cycle, no capacity is measured.

Concerning the all-solid-state secondary battery using the LiAlPO based polycrystalline solid electrolyte having undergone 450 °C heat treatment after the film deposition, a repetition characteristics test cannot be performed because the battery does not work from the beginning as has been explained in connection with FIG. 6.

FIG. 9 illustrates manufacturing yield [%] of the battery using the LiAlPO based amorphous solid electrolyte film 19 according to the embodiment, compared with that of a battery using the conventional LiPON based solid electrolyte. When using the solid electrolyte film 19 of the example, the manufacturing yield reaches 80% because fewer defects are generated and because hydrolysis hardly occurs. In contrast, with the conventional solid electrolyte, the manufacturing yield stays at 50% because pinholes and cracks are likely to be generated and hydrolysis easily occurs.

In conclusion, the solid electrolyte film 19 of the example is a uniform amorphous film with fewer pinholes and cracks. The all-solid-state secondary battery using this solid electrolyte film 19 performs stable charge and discharge operations.

The solid electrolyte of the example can be applied to all-solid-state secondary batteries used in energy harvesting devices.

## Claims

1. A method of manufacturing a solid electrolyte, comprising:
using a target with a composition of Li₉Al₃(P₂O₇)₃(PO₄)₂;
creating plasma; and
forming an amorphous solid electrolyte film containing lithium, aluminum, phosphorus, and oxygen over a substrate in an argon atmosphere, a temperature of the substrate being a room temperature during film deposition.

2. The method as claimed in claim 1, further comprising:
performing heat treatment on the solid electrolyte film at or below 400 °C.

3. The method as claimed in claim 1, wherein the solid electrolyte film is formed to a thickness of 150 nm to 1000 nm.

4. A method of manufacturing an all-solid-state secondary battery, comprising:
forming a positive electrode;
forming an amorphous solid electrolyte film over the positive electrode according to a process as claimed in claim 1; and
forming a negative electrode over the amorphous solid electrolyte film.

## Patentansprüche

1. Verfahren zur Herstellung eines Festelektrolyten, umfassend:
Benutzen eines Targets mit einer Zusammensetzung von Li₉Al₃(P₂O₇)₃(PO₄)₂;
Erzeugen eines Plasmas; und
Ausbilden einer amorphen Festelektrolytschicht, die Lithium, Aluminium, Phosphor und Sauerstoff enthält, über einem Substrat in einer Argonatmosphäre, wobei während der Schichtabscheidung eine Temperatur des Substrats eine Raumtemperatur ist.

2. Verfahren nach Anspruch 1, ferner umfassend:
Durchführen einer Wärmebehandlung an der Festelektrolytschicht bei oder unter 400 °C.

3. Verfahren nach Anspruch 1, wobei die Festelektrolytschicht bis zu einer Dicke von 150 nm bis 1000 nm ausgebildet wird.

4. Verfahren zur Herstellung einer Festkörper-Sekundärbatterie, umfassend:
Ausbilden einer positiven Elektrode;
Ausbilden einer amorphen Festelektrolytschicht über der positiven Elektrode gemäß einem Verfahren nach Anspruch 1; und
Ausbilden einer negativen Elektrode über der amorphen Festelektrolytschicht.

## Revendications

1. Procédé de fabrication d'un électrolyte solide, comprenant les étapes consistant à :
utiliser une cible avec une composition de Li₉Al₃(P₂O₇)₃(PO₄)₂ ;
créer du plasma ; et
former un film d'électrolyte solide amorphe contenant du lithium, de l'aluminium, du phosphore et de l'oxygène sur un substrat dans une atmosphère d'argon, une température du substrat étant une température ambiante pendant un dépôt de film.

2. Procédé selon la revendication 1, comprenant en outre l'étape consistant à :
effectuer un traitement thermique sur le film d'électrolyte solide à une température inférieure ou égale à 400°C.

3. Procédé selon la revendication 1, dans lequel le film d'électrolyte solide est formé à une épaisseur de 150 nm à 1 000 nm.

4. Procédé de fabrication d'une batterie secondaire entièrement à l'état solide, comprenant les étapes consistant à :
former une électrode positive ;
former un film d'électrolyte solide amorphe sur l'électrode positive selon un procédé tel que revendiqué dans la revendication 1 ; et
former une électrode négative sur le film d'électrolyte solide amorphe.
